# EUROPÄISCHE PATENTSCHRIFT

(11) **EP 1 116 420 B1**
(45) Veröffentlichungstag und Bekanntmachung des Hinweises auf die Patenterteilung: **26.06.2002**
(21) Anmeldenummer: 99952417.6
(22) Anmeldetag: 16.08.1999
(51) Int. Cl.: H05K 1/11, G01R 1/073, G01R 1/04

(54) **LEITERPLATTE ZUR VERWENDUNG BEI DER PRÜFUNG VON ELEKTRISCHEN BAUTEILEN**
PRINTED CIRCUIT PLATE USED FOR TESTING ELECTRIC COMPONENTS
PLAQUETTE A CIRCUIT IMPRIME DESTINEE A ETRE UTILISEE POUR TESTER DES COMPOSANTS ELECTRIQUES

(30) Priorität: 18.08.1998 DE 19837392
(43) Veröffentlichungstag der Anmeldung: 18.07.2001
(73) Patentinhaber: Infineon Technologies AG, 81669 München (DE)
(72) Erfinder: HACKE, Hans-Jürgen, D-81475 München (DE)
(74) Vertreter: Schweiger, Martin, Dipl.-Ing.
(86) Internationale Anmeldenummer: DE9902565
(87) Internationale Veröffentlichungsnummer: WO0011920

(56) Entgegenhaltungen:
- EP-A- 0 310 302
- DE-A- 3 608 410
- US-A- 3 818 279
- US-A- 4 676 564
- US-A- 5 065 506
- US-A- 5 510 721
- US-A- 5 537 051
- PATENT ABSTRACTS OF JAPAN vol. 1998, no. 7, 31. März 1998 (1998-03-31) -& JP 06 313788 A (FRESH QUEST CORP), 8. November 1994 (1994-11-08)
- PATENT ABSTRACTS OF JAPAN vol. 14, no. 244 (E-0932), 24. Mai 1990 (1990-05-24) & JP 02 066954 A (NITTO DENKO CORP), 7. März 1990 (1990-03-07)

## Beschreibung

Die Erfindung betrifft eine Leiterplatte zur Verwendung bei der Prüfung von elektrischen Bauelementen, die flächig verteilte Anschlußkontakte aufweisen sowie ein Verfahren zur Herstellung einer solchen Leiterplatte.

Die Prüfung von elektrischen Bauelementen läßt sich anhand der Prüfung von Chipsize- oder Chipscale-Packages erläutern. Bei diesen Bauformen von integrierten Schaltkreisen wird vor einem Einbau überprüft, ob diese dynamisch elektrisch ordnungsgemäß arbeiten. Die integrierten Schaltkreise werden in einem ersten Schritt direkt nach der Herstellung auf einem Halbleiter-Wafer statisch geprüft. Nach dem Aussägen aus dem Wafer und dem Kontaktieren in ein Chipsize-Package ist es notwendig, diese integrierten Schaltkreise erneut zu prüfen, weil sie weiteren Prozeßschritten unterworfen wurden, bei denen zusätzliche Fehlerquellen auftreten können. Dies wird durchgeführt, da der Einbau fehlerfreier Bauelemente bei den derzeit angewendeten Verbindungsverfahren mit ihren nicht mehr sicht- und kontrollierbaren Kontakten, insbesondere bei Multichipmodulen Voraussetzung ist, um eine tragbare Gesamtausbeute zu erreichen.

**Aus der Druckschrift US 5,510,721 ist dazu eine Testvorrichtung zum Prüfen einer integrierten Schaltung bekannt. Die Testvorrichtung verwendet leitende Streifen, die sich über Gräben erstrecken. Die Streifen sind zu Anschlusskontakten auf der integrierten Schaltung ausgerichtet. Wenn diese Bondkontakte oder Anschlusskontakte der integrierten Schaltung mit den Streifen in Kontakt gebracht werden, üben die Streifen eine Gegenkraft in entgegengesetzter Richtung aus, um einen guten elektrischen Kontakt während der Prüfung der integrierten Schaltung sicherzustellen.**

Die elektrische Prüfung **mit bekannten Testvorrichtungen** gestaltet sich gerade im Fall von elektrischen Bauelementen, die eine Vielzahl von Kontakten aufweisen, problematisch. Solche Bauelemente weisen häufig kugelförmige Anschlußhöcker auf, die sich nur schwer mit Prüfnadeln von Testadaptern **oder den bekannten metallischen Teststreifen** kontaktieren lassen. Bei der Prüfung mit Prüfnadeln kann es weiterhin auftreten, daß die Prüfnadeln den geprüften integrierten Schaltkreis beschädigen.

**Aus der Druckschrift US 5,065,506 ist ein Verfahren zur Herstellung einer Leiterplatte bekannt, das eine elektrische Leitung auf einer Seite eines Substrats bereitstellt und ein selektives Bestrahlen der anderen Seite des Substrats mit einem Laserstrahl durchführt, so daß ein Abschnitt des Substrats sublimiert. Dabei wird eine Öffnung freigelegt, die von einer Leitung überquert wird. Diese Leitung wird anschließend auf Kontaktflächen eines elektrischen Bauelements gebondet.**

Der Erfindung liegt die Aufgabe zugrunde, eine Leiterplatte und ein Verfahren zur Verwendung bei der Prüfung von elektrischen Bauelementen bereitzustellen, welche die Prüfung vereinfacht.

Diese Aufgabe wird durch den Gegenstand der unabhängigen Ansprüche gelöst. Vorteilhafte Weiterbildungen ergeben sich aus den jeweiligen Unteransprüchen.

Gemäß der Erfindung weist eine Leiterplatte zur Verwendung bei der Prüfung von elektrischen Bauelementen die folgenden Merkmale auf:
- eine elektrisch isolierende Isolationsschicht, die mit Durchgangsöffnungen versehen ist,
- im Bereich je einer Durchgangsöffnung ist auf einer Oberflächenseite der Isolationsschicht ein elektrisch leitender Kontaktfleck vorgesehen, **so daß je ein Kontaktpunkt des elektrischen Bauelementes mit einem Kontaktfleck der Leiterplatte in Berührung kommt,**
- ausgehend von je einem Kontaktfleck erstreckt sich je eine Leiterbahn insbesondere zu einem Randbereich der Isolationsschicht, **wobei wenigstens im Bereich der Durchgangsöffnungen unterhalb der Kontaktflecke elastische Federelemente so angeordnet sind, daß die Kontaktflecke jeweils mit einem Federelement in Kontakt treten.**

Die Erfindung beruht auf dem Grundgedanken, eine insbesondere flexible Teststruktur bereitzustellen, die eine elastische Andruckverbindung mit Kontaktpunkten von elektrischen Bauelementen bereitstellt. Das elektrische Bauelement kann mit seinen Kontaktpunkten so auf die erfindungsgemäße Leiterplatte aufgedrückt werden, daß je ein Kontaktpunkt des elektrischen Bauelements mit einem Kontaktfleck der Leiterplatte in Berührung kommt. Der Kontaktfleck, der sich insbesondere über der Durchgangsöffnung befindet, kann in die Durchgangsöffnung hinein oder aus der Durchgangsöffnung heraus nachgeben und so Toleranzen in der Ausbildung von Kontaktpunkten des elektrischen Bauelements ausgleichen. Darüber hinaus wird eine Beschädigung von Kontaktpunkten des elektrischen Bauelements vermieden.

Die elastischen Federelemente können auch so angeordnet sein, daß die Kontaktflecke durch die Durchgangsöffnungen hindurch jeweils mit einem Federelement in Kontakt treten. Mit diesen Ausgestaltungen ist es möglich, die Nachgiebigkeit der Kontaktflecke unabhängig von ihrer Position bezüglich den Durchgangsöffnungen genau einzustellen.

In einer ersten Ausführungsform liegen die Kontaktflecke zwischen der Isolationsschicht und dem elastischen Federelement. Dann kann ein Kontaktelement eines elektrischen Bauelements durch die Durchgangsöffnungen hindurch mit dem Kontaktfleck in Verbindung treten, wobei das Federelement Toleranzunterschiede zwischen dem Kontaktfleck und Anschlußhöcker ausgleicht. Alternativ dazu kann das elastische Federelement auch innerhalb der Durchgangsöffnung angeordnet sein, wobei der Kontaktfleck von einem Kontaktpunkt eines elektrischen Bauelements gegen den Widerstand des Federelements in die Durchgangsöffnung hineindrückbar ist.

Die Federelemente können als vorzugsweise zusammenhängende Bereiche einer elastischen Gegenschicht ausgebildet sein, die Silikonkautschuk aufweisen kann. Dadurch läßt sich eine besonders einfache Herstellung der erfindungsgemäßen Leiterplatte erreichen.

Die Kontaktflecke können auch wenigstens teilweise freitragend in den Durchgangsöffnungen angeordnet sein, wodurch sich eine vereinfachte und zuverlässige Benutzung der erfindungsgemäßen Leiterplatte erreichen läßt.

Die Erfindung ist auch in einem Verfahren zur Herstellung einer erfindungsgemäßen Leiterplatte verwirklicht, wobei das Verfahren die folgenden Schritte aufweist:
- Vorsehen einer zumindest einseitig mit einer leitenden Metallschicht kaschierten, elektrisch isolierenden Isolationsschicht,
- Erzeugen von Durchgangsöffnungen an zum Kontakt mit den Anschlußkontakten eines elektrischen Bauelements bestimmten Orten in einer Isolationsschicht, **so daß je ein Kontaktpunkt des elektrischen Bauelements mit einem Kontaktfleck der Leiterplatte in Berührung kommt,**
- Erzeugen von Leiterbahnen in der Metallschicht, wobei sich die Leiterbahnen jeweils ausgehend von einem Bereich einer Durchgangsöffnung insbesondere zu einem Randbereich der Isolationsschicht erstrecken,
- **wobei wenigstens im Bereich der Durchgangsöffnungen (3; 12) unterhalb der Kontaktflecke (4; 14) elastische Federelemente so angeordnet werden, daß die Kontaktflecke (4; 14) jeweils mit einem Federelement in Kontakt treten.**

Dabei kann die mit einer leitenden Metallschicht kaschierte elektrisch isolierende Isolationsschicht bereitgestellt werden. Solche Trägermaterialien sind günstig erhältlich, so daß die Herstellung der erfindungsgemäßen Leiterplatte ökonomisch durchführbar ist.

Die Durchgangsöffnungen zum Kontakt mit den Anschlußkontakten an bestimmten Orten werden in der Isolationsschicht vorzugsweise durch Laserablation unter Verwendung einer Maske vorgenommen, während das Erzeugen von Leiterbahnen in der Metallschicht beispielsweise mittels eines fotolithographischen und ätztechnischen Verfahrens durchführbar ist.

Die Verwendung von Laserablation gestattet es, bereits kaschierte Trägermaterialien in dem erfindungsgemäßen Verfahren zu verwenden, da mit der Laserablation nur die Isolationsschicht abtragbar ist, während die Kupferkaschierung im Bereich der Durchgangsöffnung verbleibt.

Das Erzeugen der Durchgangsöffnung kann auch durch chemisches und/oder physikalisches Ätzen oder durch Stanzen erfolgen.

Wenn der Schritt des Erzeugens von Kontaktflecken vorgesehen ist, und zwar jeweils als Abschnitt einer Leiterbahn in einem Bereich einer Durchgangsöffnung, dann läßt sich eine Leiterplatte herstellen, die im Einsatz besonders zuverlässig funktioniert. Solche Kontaktflecke können beispielsweise durch Abscheiden eines Metalls, insbesondere Gold, dauerhaft gegen Korrosion geschützt werden.

Bei den erfindungsgemäßen Verfahren und bei der erfindungsgemäßen Leiterplatte besteht die Basis der Herstellung der flexiblen Teststruktur auf der Verwendung *von* Prozeßschritten, die auch bei der Spiderherstellung für die TAB-Montage (Tape Automated Bonding) angewandt werden. Dabei können besonders feine Leiterstrukturen insbesondere auch freitragend über Öffnungen im Trägermaterial hergestellt werden.

Im vorliegenden Fall wird dieses Verfahren dazu genutzt, um freitragende; vergoldete Kontaktflecke für zu prüfende Anschlüsse eines elektrischen Bauelements zu schaffen. Auf diese Kontaktflecke wird dann das elektrische Bauelement gedrückt, so daß über ein dahinter angebrachtes Federelement zum Beispiel aus Silikonkautschuk sowohl Toleranzen ausgeglichen werden als auch ein guter elektrischer Prüfkontakt geschaffen wird. Von den Kontaktflecken führen Leiterbahnen zu Anschlüssen in einem gröberen Raster, die auf üblichem Wege mit Testsockeln und anderen Elementen verbunden werden können.

Die Öffnungen in der Trägerfolie, in die die Kontaktflecken hineinragen, können auf verschiedene Weisen hergestellt werden. So ist chemisches oder Plasma-Ätzen ebenso anwendbar wie Methoden des Laserabtrags. Die Anwendbarkeit des Stanzens hängt von der Rasterfeinheit und dem Lochdurchmesser der Durchgangsöffnungen ab.

Anders als üblich ist im erfindungsgemaßen Fall eine gewisse Kantenschräge des Lochquerschnitts der Durchgangsöffnungen erwünscht. Wird nämlich im Prüffall das Bauelement von der Öffnungsseite her auf die Teststruktur gedrückt, so erfolgt durch die Lochkanten ein Zentriereffekt, der die erforderliche Positioniergenauigkeit entsprechend erhöht.

Das Bauelement kann in einer Variante aber auch von der anderen Seite angedrückt werden. In diesem Fall muß das federnde Material die Öffnungen ausfüllen, was durch Auflegen der Folie beispielsweise auf ein flüssiges Bett aus Silikonkautschuk mit anschließendem Härten erreicht werden kann.

Der Andruck des Bauelements erfolgt vorzugsweise hinsichtlich Druck und Lage definiert. Hierfür können Montagegeräte verwendet werden, die auf einfache Weise eine genaue Zuordnung von Bauelement und der erfindungsgemäßen Leiterplatte erreichen.
- Figur 1: zeigt eine Draufsicht auf eine erfindungsgemäße Leiterplatte,
- Figur 2: zeigt einen Querschnitt durch eine weitere erfindungsgemäße Leiterplatte im Bereich einer Durchgangsöffnung,
- Figur 3: zeigt einen Querschnitt durch eine weitere erfindungsgemäße Leiterplatte im Bereich einer weiteren Durchgangsöffnung,
- Figur 4: zeigt einen Querschnitt durch ein zu prüfendes elektrisches Bauelement sowie durch die erfindungsgemäße Leiterplatte nach Figur 3 im Bereich von zwei Durchgangsöffnungen,
- Figur 5: zeigt einen Querschnitt durch ein weiteres elektrisches Bauelement sowie durch die erfindungsgemäße Leiterplatte nach Figur 2 im Bereich von weiteren Durchgangsöffnungen und
- Figur 6: zeigt eine Draufsicht auf eine weitere erfindungsgemäße Leiterplatte.

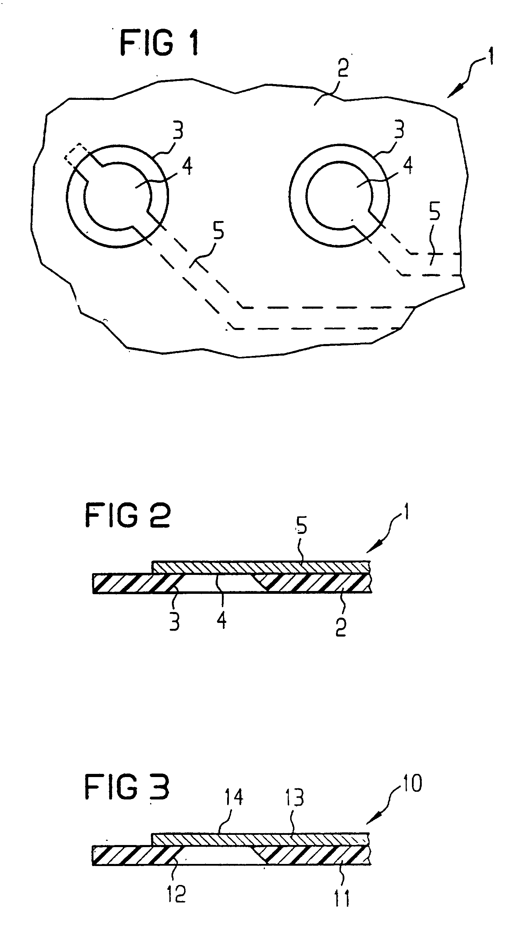

Figur 1 zeigt eine Draufsicht auf eine erfindungsgemäße Leiterplatte 1. Die Leiterplatte 1 gliedert sich in eine elektrisch isolierende Isolationsschicht 2, die Durchgangsöffnungen 3 aufweist.

Innerhalb der Durchgangsöffnungen 3 sind elektrisch leitende Kontaktflecke 4 freischwebend angeordnet, die vergoldet sind. Weiterhin sind auf der Unterseite der Isolationsschicht 2 Leiterbahnen 5 vorgesehen, die sich über die Durchgangsöffnungen hinweg erstrecken und die mit den Kontaktflecken 4 verbunden sind.

Zur Herstellung der Leiterplatte 1 werden in einem kupferkaschierten Trägermaterial von z. B. 50 µm Dicke die Durchgangsöffnungen 3 erzeugt und zwar durch Laserablation unter Verwendung einer in dieser Ansicht nicht gezeigten Maske.

Danach wird die Kupferkaschierung, die in Figur 1 auf der Rückseite der Isolationsschicht 2 vorgesehen ist, mit Photolack beschichtet und die Struktur der Leiterbahnen 5 paßgenau zum Offnungsbild belichtet. Auf das Entwickeln des in dieser Ansicht nicht gezeigten Photolacks hin wird die Kupferkaschierung geätzt und entschichtet. Abschließend werden insbesondere die Kontaktflecke 4 mit Gold beschichtet.

Figur 2 zeigt einen Bereich der Leiterplatte 1 um eine Durchgangsöffnung 3 herum im Querschnitt. Wie man in dieser Ansicht besonders gut sieht, erstreckt sich der Kontaktfleck 4 ausgehend von der Leiterbahn 5 in die Durchgangsöffnung 3 hinein. Eine Kantenschräge der Durchgangsöffnung 3 zum Kontaktfleck 4 hin ist erwünscht.

Figur 3 zeigt einen Teilbereich einer weiteren Leiterplatte 10 im Querschnitt.

Die Leiterplatte 10 gliedert sich in eine Isolationsschicht 11, in der eine Durchgangsoffnung 12 vorgesehen ist. Oberhalb der Isolationsschicht 11 ist eine Leiterbahn 13 abgelagert, in der ein kreisrunder Kontaktfleck 14 hergestellt ist, der mit Gold beschichtet ist.

Die Leiterplatte 10 ist mit einem TAB-Verfahren (= Tape-Automated-Bonding-Verfahren) hergestellt.

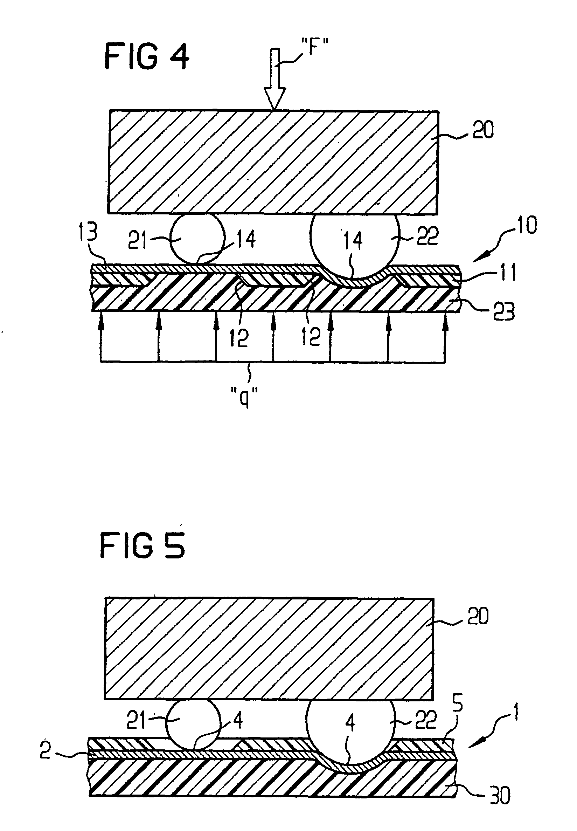

Figur 4 zeigt die Leiterplatte 10 aus Figur 3 beim Einsatz mit einem zu prüfenden elektrischen Bauelement 20, das an seiner Unterseite einen ersten Kontakthöcker 21 mit im wesentlichen kugelförmigem Durchmesser sowie einen zweiten Kontakthöcker 22 mit im wesentlichen kugelförmigem Querschnitt aufweist. Der Durchmesser des zweiten Kontakthöckers 22 ist innerhalb des Toleranzbereichs wesentlich größer als der Durchmesser des ersten Kontakthöckers 21.

Wie man in Figur 4 besonders deutlich sieht, sind die Durchgangsöffnungen 12 so in der Isolationsschicht 11 angeordnet, daß diese genau unter dem ersten Kontakthöcker 21 bzw. unter dem zweiten Kontakthöcker 22 liegen. Dabei berührt der erste Kontakthöcker 21 gerade den Kontaktfleck 14 der in Figur 4 auf der linken Seite gezeigten Durchgangsöffnung, während der zweite Kontäkthöcker 22 den Kontaktfleck 14 der in Figur 4 auf der rechten Seite gezeigten Durchgangsöffnung nach unten drückt.

Zur Erhöhung des Durchbiegewiderstands der Kontaktflecke 14 ist unterhalb der Isolationsschicht 11 eine Federschicht 23 aus Silikonkautschuk vorgesehen, die auf einer festen Unterlage aufliegt, die in dieser Ansicht nicht gezeigt ist. Einer Anpreßkraft "F" auf das elektrisch Bauelement 20 wirkt die Federschicht 23 mit einer Flächenlast "q" entgegen.

Durch die Ausbildung der Kontaktflecke 14 im Zusammenhang mit der biegsamen Leiterbahn 13 werden Größentoleranzen zwischen erstem Kontakthöcker 21 und zweitem Kontakthöcker 22 ausgeglichen, wie in Figur 4 besonders gut zu sehen ist.

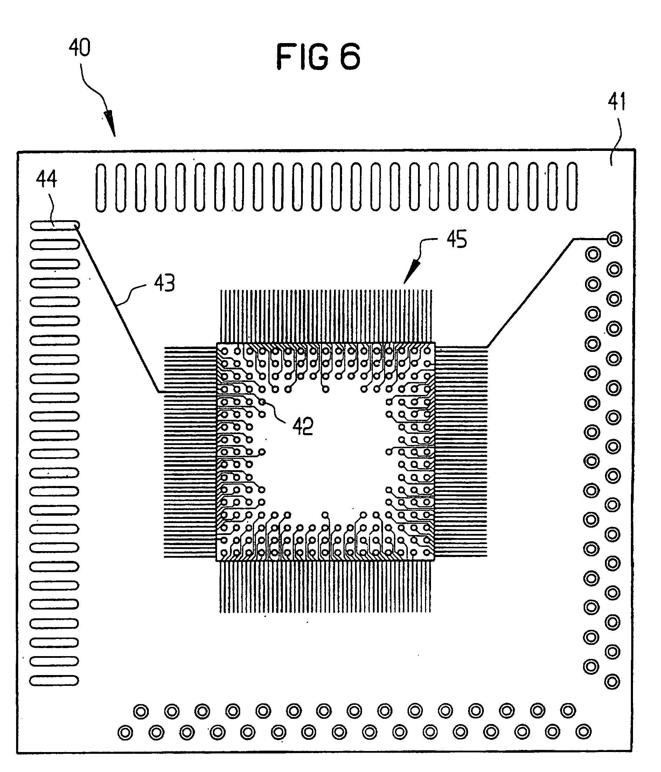

Figur 5 zeigt die erfindungsgemäße Leiterplatte 1 aus Figur 2 im Zusammenhang mit dem elektrischen Bauelement 20 aus Figur 4. Unterhalb der Isolationsschicht 2 sowie der Leiterbahnen 5 ist eine Federschicht 30 vorgesehen, die einer Verformung der Kontaktflecke 4 nach unten unter Einwirkung des ersten Kontakthöckers 21 bzw. des zweiten Kontakthöckers 22 entgegenwirkt. Wie man in dieser Ansicht besonders gut sieht, wird durch diese Ausgestaltung ein Toleranzenausgleich aufgrund der unterschiedlichen Größen von erstem Kontakthöcker 21 und zweitem Kontakthöcker 22 gewährleistet.

Figur 6 zeigt eine weitere erfindungsgemäße Leiterplatte 40 in der Draufsicht. Die Leiterplatte 40 weist eine Isolationsschicht 41 auf, auf der eine Kupferkaschierung aufgebracht ist. In der Kupferkaschierung sind eine Reihe von Leiterbahnen ausgebildet worden, die zur Prüfkontaktierung eines Bauteils ausgebildet sind. Dabei ist jedem untenseitig an einem in dieser Ansicht nicht gezeigten elektrischen Bauelement vorhandenen Kontakthöcker eine Durchgangsöffnung mit Kontaktfleck zugeordnet, wie sie in den Figuren 3 und 4 näher beschrieben ist. Beispielhaft wird hier ein Kontaktfleck 42 herausgegriffen, der über eine Leiterbahn 43 mit einem Grobanschluß 44 am Rand der Isolationsschicht 41 in Verbindung steht. Ebenso stehen auch alle anderen Kontaktflecke in einem Kontaktbereich 45 der Leiterplatte 40 mit Grobanschlüssen am Umfang der Leiterplatte 40 in Verbindung.

Zur Überprüfung eines elektrischen Bauelements, dessen Kontakthöcker so angeordnet sind wie die Kontaktflecke im Bauelementbereich des Kontaktbereichs 45, wird das Bauteil auf den Kontaktbereich 45 aufgepreßt. Daraufhin können alle Kontakthöcker des elektrischen Bauelements über die Grobanschlüsse am Umfang der Leiterplatte 40 abgetastet werden.

## Patentansprüche

1. Leiterplatte (1; 10; 40) zur Verwendung bei der Prüfung von elektrischen Bauelementen (20), die flächig verteilte Anschlußkontakte (21, 22) aufweisen, wobei die Leiterplatte (1; 10; 40) die folgenden Merkmale aufweist:
- eine elektrisch isolierende Isolationsschicht (2; 11; 41), die mit Durchgangsöffnungen (3; 12) versehen ist;
- im Bereich je einer Durchgangsöffnung (3; 12) ist auf einer Oberflächenseite der Isolationsschicht (2; 11; 41) ein elektrisch leitender Kontaktfleck (4; 14; 42) vorgesehen, **so daß je ein Kontaktpunkt des elektrischen Bauelementes (20) mit einem Kontaktfleck (4; 14; 42) der Leiterplatte in Berührung kommt,**
- ausgehend von je einem Kontaktfleck (4; 14; 42) erstreckt sich je eine Leiterbahn (5; 13; 43) insbesondere zu einem Randbereich der Isolationsschicht (2; 11; 41).
**dadurch gekennzeichnet, dass**
wenigstens im Bereich der Durchgangsöffnungen (3; 12) unterhalb der Kontaktflecke (4; 14) elastische Federelement so angeordnet sind, daß die Kontaktflecke (4; 14) jeweils mit einem Federelement in Kontakt treten.

2. Leiterplatte nach Anspruch 1,
**dadurch gekennzeichnet, daß**
wenigstens im Bereich der Durchgangsöffnungen (3; 12) unterhalb der Kontaktflecke (4; 14) elastische Federelement so angeordnet sind, daßdie Kontaktflecke (4; 14) durch die Durchgangsöffnungen (3; 13) jeweils mit einem Federelement in Kontakt treten.

3. Leiterplatte nach Anspruch 1 oder Anspruch 2,
**dadurch gekennzeichnet, daß**
die Federelemente als vorzugsweise zusammenhängende Bereiche einer elastischen Gegenschicht (23; 30) ausgebildet sind.

4. Leiterplatte nach Anspruch 3,
**dadurch gekennzeichnet, daß**
daß die Gegenschicht (23; 30) Silikonkautschuk aufweist.

5. Leiterplatte nach einem der vorhergehenden Ansprüche,
**dadurch gekennzeichnet, daß**
die Kontaktflecke (4; 14) wenigstens freitragend in den Durchgangsöffnungen (3; 12) angeordnet sind.

6. Verfahren zur Herstellung einer Leiterplatte, die zur Verwendung insbesondere bei der Prüfung von elektrischen Bauelementen bestimmt ist, die flächig verteilte Anschlußkontakte aufweisen, wobei das Verfahren die folgenden Schritte aufweist:
- Vorsehen einer zumindest einseitig mit einer leitenden Metallschicht kaschierten, elektrisch isolierenden Isolationsschicht,
- Erzeugen von Durchgangsöffnungen an zum Kontakt mit den Anschlußelementen bestimmten Orten in der Isolationsschicht, **so daß je ein Kontaktpunkt des elektrischen Bauelementes (20) mit einem Kontaktfleck (4; 14; 42) der Leiterplatte in Berührung kommt,**
- Erzeugen von Leiterbahnen in der Metallschicht, wobei sich die Leiterbahnen jeweils ausgehend von einem Bereich einer Durchgangsöffnung insbesondere zu einem Randbereich der Isolationsschicht erstrecken,
- **wobei wenigstens im Bereich der Durchgangsöffnungen (3; 12) unterhalb der Kontaktflecke (4; 14) elastische Federelemente so angeordnet werden, daß die Kontaktflecke (4; 14) jeweils mit einem Pederelement in Kontakt treten.**

7. Verfahren nach Anspruch 6,
**dadurch gekennzeichnet, daß**
die mit einer leitenden Metallschicht kaschierte, elektrisch isolierende Isolationsschicht als einseitig kupferkaschiertes Trägermaterial bereitgestellt wird.

8. Verfahren nach Anspruch 6 oder 7,
**dadurch gekennzeichnet, daß**
das Erzeugen von Durchgangsöffnungen an zum Kontakt mit den Anschlußelementen bestimmten Orten in der Isolationsschicht durch Laserablation unter Verwendung einer Maske vorgenommen wird.

9. Verfahren nach einem der Ansprüche 6 bis 8,
**dadurch gekennzeichnet, daß**
das Erzeugen von Leiterbahnen in der Metallschicht mittels eines photolithographischen und ätztechnischen Verfahrens vorgenommen wird.

10. Verfahren nach einem der Ansprüche 6 bis 9,
**dadurch gekennzeichnet, daß**
der Schritt des Erzeugens von Kontaktflecken vorgesehen ist, und zwar jeweils als Abschnitt einer Leiterbahn in einem Bereich einer Durchgangsöffnung.

11. Verfahren nach Anspruch 10,
**dadurch gekennzeichnet, daß**
nach dem Schritt des Erzeugens von Kontaktflecken der Schritt des Abscheidens eines Metalls, insbesondere von Gold auf den Kontaktflecken vorgenommen wird.

## Claims

1. Printed circuit board (1; 10; 40) for use in the testing of electrical components (20) having areally distributed connection contacts (21, 22), the printed circuit board (1; 10; 40) having the following features:
- an electrically insulating insulation layer (2; 11; 41) provided with through openings (3; 12);
- in the region of a respective through opening (3; 12), an electrically conductive contact pad (4; 14; 42) is provided on a surface side of the insulation layer (2; 11; 41), with the result that a respective contact point of the electrical component (20) comes into contact with a contact pad (4; 14; 42) of the printed circuit board,
- proceeding from a respective contact pad (4; 14; 42), a respective conductor track (5; 13; 43) extends, in particular, to an edge region of the insulation layer (2; 11; 41),
**characterized in that**
at least in the region of the through openings (3; 12) below the contact pads (4; 14), elastic spring elements are arranged in such a way that the contact pads (4; 14) each make contact with a spring element.

2. Printed circuit board according to Claim 1,
**characterized in that**
at least in the region of the through openings (3; 12) below the contact pads (4; 14), elastic spring elements are arranged in such a way that the contact pads (4; 14) each make contact with a spring element, through the through openings (3; 13).

3. Printed circuit board according to Claim 1 or Claim 2,
**characterized in that**
the spring elements are designed as preferably contiguous regions of an elastic mating layer (23; 30).

4. Printed circuit board according to Claim 3,
**characterized in that**
the mating layer (23; 30) has silicone rubber.

5. Printed circuit board according to one of the preceding claims,
**characterized in that** the contact pads (4; 14) are arranged at least in a self-supporting manner in the through openings (3; 12).

6. Method for producing a printed circuit board intended for use in particular in the testing of electrical components having areally distributed connection contacts, the method having the following steps:
- provision of an electrically insulating insulation layer which is coated at least on one side with a conductive metal layer,
- production of through openings at locations in the insulation layer which are intended for contact with the connection elements, with the result that a respective contact point of the electrical component (20) comes into contact with a contact pad (4; 14; 42) of the printed circuit board,
- production of conductor tracks in the metal layer, the conductor tracks, in each case proceeding from a region of a through opening, extending in particular to an edge region of the insulation layer,
- at least in the region of the through openings (3; 12), below the contact pads (4; 14), elastic spring elements being arranged in such a way that the contact pads (4;14) each make contact with a spring element.

7. Method according to Claim 6,
**characterized in that**
the electrically insulating insulation layer which is coated with a conductive metal layer is provided as support material coated with copper on one side.

8. Method according to Claim 6 or 7,
**characterized in that**
the production of through openings at locations in the insulation layer which are intended for contact with the connection elements is performed by laser ablation using a mask.

9. Method according to one of Claims 6 to 8,
**characterized in that**
the production of conductor tracks in the metal layer is performed by means of a photolithographic and etching method.

10. Method according to one of Claims 6 to 9,
**characterized in that**
the step of producing contact pads is provided, to be precise in each case as a section of a conductor track in a region of a through opening.

11. Method according to Claim 10,
**characterized in that**
after the step of producing contact pads, the step of depositing a metal, in particular gold, on the contact pads is performed.

## Revendications

1. Plaquette (1 ; 10 ; 40) à circuit imprimé destinée à être utilisée pour le contrôle de composants (20) électriques qui présentent des contacts (21, 22) de connexion répartis à plat. La plaquette (1 ; 10 ; 40) à circuit imprimé ayant les caractéristiques suivantes :
- une couche (2 ; 11 ; 41) d'isolement, isolante du point de vue électrique qui est munie d'ouvertures (3 ; 12) de traversée ;
- il est prévu, dans la partie de chaque ouverture (3 ; 12) de traversée, sur un côté de surface de la couche (2 ; 11 ; 41) d'isolement, une plage (4 ; 14 ; 42) de contact qui est conductrice de l'électricité, de sorte que respectivement un point de contact du composant (20) électrique vienne en contact avec une plage (4 ; 14 ; 42) de contact de la plaquette à circuit imprimé ;
- à partir de respectivement une plage (4 ; 14 ; 42) de contact, respectivement, une piste (5 ; 13 ; 43) conductrice s'étend notamment vers une partie de bord de la couche (2 ; 11 ; 41) d'isolement,
**caractérisée en ce qu'**au moins dans la partie des ouvertures (3 ; 12) de traversée, il est monté, en dessous des plages (4 ; 14) de contact, des éléments élastiques de façon que les plages (4 ; 14) de contact viennent respectivement en contact avec un élément élastique.

2. Plaquette à circuit imprimé suivant la revendication 1, **caractérisée en ce qu'**au moins dans la partie des ouvertures (3 ; 12) de traversée, il est prévu, en dessous des plages (4 ; 14) de contact, des éléments élastiques de façon que les plages (4 ; 14) de contact viennent en contact par les ouvertures (3 ; 13) de traversée respectivement avec un élément élastique.

3. Plaquette à circuit imprimé suivant la revendication 1 ou la revendication 2, **caractérisée en ce que** les éléments élastiques sont constitués, de préférence, sous la forme de parties d'un seul tenant d'une couche (23 ; 30) élastique antagoniste.

4. Plaquette à circuit imprimé suivant la revendication 3, **caractérisée en ce que** la couche (23 ; 30) antagoniste comprend du caoutchouc de silicone.

5. Plaquette à circuit imprimé suivant l'une des revendications précédentes, **caractérisée en ce que** les plages (4 ; 14) de contact sont disposées au moins en porte-à-faux dans les ouvertures (3 ; 12) de traversée.

6. Procédé de fabrication d'une plaquette à circuit imprimé qui est destinée à être utilisée notamment lors du contrôle de composants électriques qui ont des contacts de connexion répartis à plat, le procédé comportant les stades suivants :
- on prévoit une couche d'isolement, isolante du point de vue électrique et plaquée au moins d'un côté d'une couche métallique conductrice,
- on produit des ouvertures de traversée en des emplacements de la couche d'isolement destinées à venir en contact avec les éléments de connexion, de sorte que respectivement un point de contact du composant (20) électrique vienne en contact avec une plage (4 ; 14 ; 42) de contact de la plaquette à circuit imprimé,
- on produit des pistes conductrices dans la couche métallique, les pistes conductrices s'étendant respectivement à partir d'une partie d'une ouverture de traversée, notamment vers une partie de bord de la couche d'isolement,
- on dispose au moins dans la partie des ouvertures (3 ; 12) de traversée en dessous des plages (4; 14) de contact, des éléments élastiques de façon que les plages (4 ; 14) de contact viennent respectivement en contact avec un élément élastique.

7. Procédé suivant la revendication 6, **caractérisé en ce que** la couche d'isolement, isolante du point de vue électrique et plaquée d'une couche métallique conductrice est mise sous la forme d'un matériau support plaqué d'un côté de cuivre.

8. Procédé suivant la revendication 6 ou 7, **caractérisé en ce que** l'on effectue la production d'ouvertures de traversée en des emplacements de la couche d'isolement destinés au contact avec les éléments de connexion par ablation par laser en utilisant un masque.

9. Procédé suivant l'une des revendications 6 à 8, **caractérisé en ce que** l'on effectue la production de pistes conductrices dans la couche métallique au moyen d'un procédé photolithographique et par une technique d'attaque chimique.

10. Procédé suivant l'une des revendications 6 à 9, **caractérisé en ce que** l'on prévoit le stade de production de plages de contact et de fait, respectivement, sous la forme d'un tronçon d'une piste conductrice dans une partie d'une ouverture de traversée.

11. Procédé suivant la revendication 10, **caractérisé en ce, qu'**après le stade de production de plages de contact, on effectue le stade de dépôt d'un métal, notamment d'or sur les plages de contact.
